Europäisches Patentamt

European Patent Office

Office européen des brevets

(19)

(11) Publication number: **0 256 568 B1**

(12) **EUROPEAN PATENT SPECIFICATION**

(45) Date of publication of patent specification: **11.09.91** (51) Int. Cl.⁵: **H01L 21/70**

(21) Application number: **87201179.6**

(22) Date of filing: **19.06.87**

(54) **Process for obtaining thin-film circuits and passive circuit made by said process.**

(30) Priority: **15.07.86 IT 2112686**

(43) Date of publication of application:
**24.02.88 Bulletin 88/08**

(45) Publication of the grant of the patent:
**11.09.91 Bulletin 91/37**

(84) Designated Contracting States:
**BE CH DE FR GB GR IT LI NL SE**

(56) References cited:
**DE-A- 3 200 983**
**US-A- 4 226 932**

**NAVY TECHNICAL DISCLOSURE BULLETIN,
vol. 8, no. 4, June 1983, pages 83-86, Wash-
ington, US; H. MORRIS: "A dual resistivity
thin film hybrid microcircuit"**

**PATENT ABSTRACTS OF JAPAN, vol. 5, no.
34 (E-48)[706], 4th March 1981; & JP-A-55 162
254 0**

(73) Proprietor: **SIEMENS TELECOMUNICAZIONI
S.P.A.**
**SS. 11 Padana Superiore Km. 158**
**I-20060 Cassina de Pecchi (Milano)(IT)**

(72) Inventor: **Ferraris, Giampiero**
**Via Rossini, 17**
**I-22068 Monticello (Como)(IT)**
Inventor: **Tersalvi, Antonio**
**Via Gallarate, 105**
**I-20151 Milano(IT)**

(74) Representative: **Mittler, Enrico et al**
**c/o Marchi & Mittler s.r.l. Viale Lombardia, 20**
**I-20131 Milano(IT)**

## Description

The present invention relates to a process for obtaining thin-layer passive circuits with resistive lines of different layer resistances as well as the passive circuit made by said process.

There is a known need of accomplishing on the same substrate of a passive thin-layer circuit two different types of resistive lines having different layer resistances.

Recent techniques provide for accomplishment of resistive lines having greater resistance by means of individual thin layers of a first material having greater resistivity and resistive lines having less resistance by superimposing on said thin layers an additional layer of a second material having less resistivity.

In accordance with a first technique the material with greater resistivity is a ceramic-metal alloy (CERMET) and the material with less resistivity is a nickel-chromium alloy.

In accordance with another technique the material with less resistivity is a titanium-palladium alloy and the material with greater resistivity is tantalum nitride ($Ta_2N$).

In accordance with the article of H. Morris titled: "A dual resisting thin film hybrid microcircuit" published in the Navy Technical Disclosure Bulletin, Vol. 8, No. 4, June 1983, pagg. 83-86, Washington, the material with high resistivity is a mixture such as 27 atomic percent chromium, and the material with low resistivity is tantalum nitride.

The Siemens patent DE 3200983 describes a passive thin layer circuit with resistive lines having different layer resistances formed by superposition of an upper NiCr layer having less resistivity to a lower CrSi layer having greater resistivity.

All said techniques display the drawback of requiring very complicated, long and costly production processes. In particular they require a photoengraving step after deposit of the first material.

A second drawback of the cited prior art is that in all the mentioned structures the temperature coefficients (TCR) of the two layers having different resistivity have too much high values and poor temperature stabilities into the temperature utilization range.

A third drawback is that the said temperature coefficients of the two layers show values very different from each other, sometimes having different sign, consequently the temperature variation amplifies the value of resistive gap between the two type of resistors.

A thin film multilayer structure is also described in the patent US 4226932. In this structure a layer of titanium nitride is used between the tantalum nitride and the palladium layer. This structure, however, is not suitable to obtain, in an easy way, resistive lines having different resistive values on the same substrate. In fact, because of the low resistivity value of the tantalum nitride layer, an high value resistive line should be either too long or too narrow.

The purpose of the present invention is to accomplish a passive thin-layer circuit with resistive lines having different layer resistances by a simpler, more rapid and economical process more profitable in the end than those in accordance with presently known techniques.

In addition both the layer resistances of the present invention have a low temperature coefficient of the same sign (negative) and greatly stable in temperature, allowing to obtain very precise value resistances.

In accordance with the invention said purpose is achieved by means of a process whose main feature is that tantalum treated with a first dopant consisting of nitrogen and oxygen is used for the lower layer and titanium treated with a second dopant consisting of nitrogen is used for the upper layer.

In this manner two materials compatible with titanium can be superimposed and then, being doped differently, subjected to selective chemical etching to accomplish depending on the case singlelayer resistive lines having greater resistance and double-layer resistive lines having less resistance.

According to another important feature of the process in accordance with the present invention on the titanium layer is superimposed a thin layer of palladium which acts as a barrier against spreading of the titanium into the conductive layers subsequently superimposed.

In this manner the titanium can act as an adhesive layer for the conductive layers without giving rise to undesired spreading problems.

The details of the process in accordance with the invention will now be described with reference to the annexed drawings wherein:

FIGS. 1-16 are vertical sectional views showing the various steps of the process in accordance with the invention, and

FIG. 17 is a plan view of a portion of the passive circuit obtained at the end of the process illustrated in the preceding figures.

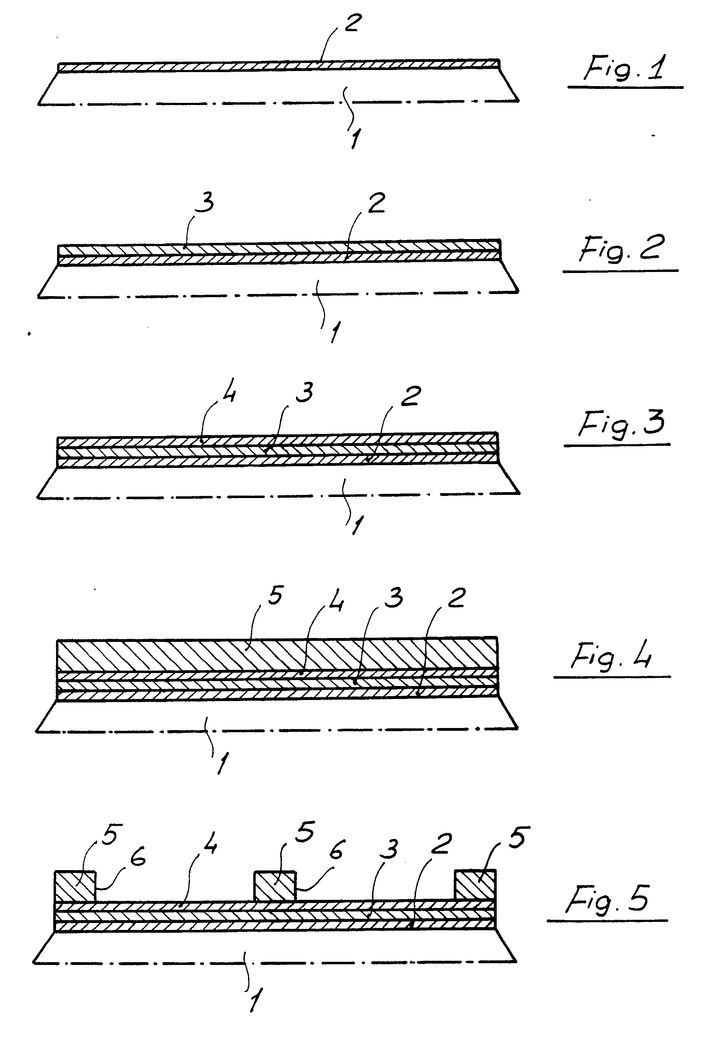

As shown in FIG. 1, on an insulating substrate 1 (alumina, quartz, glass) is initially deposited by cathodic pulverization in a vacuum a layer of tantalum 2 doped with nitrogen and oxygen (i.e. tantalum oxynitride Ta-O-N) having a resistivity of 350-450 $\mu$ohm.cm and a thickness of approximately 30nm (300Å).

In the same vacuum cycle is then superimposed by cathodic pulverization in a vacuum a layer of titanium 3 doped with nitrogen (i.e. titanium nitride TiN) having a resistivity of 200-250 μohm.cm and a thickness of approximately 100nm (1000Å) (FIG. 2).

In the same vacuum cycle again is also superimposed by cathodic pulverization in a vacuum a layer of palladium 4 with the function of a barrier against spreading in relation to the underlying layer of titanium 3 (FIG. 3).

On the structure thus formed is superimposed a thick layer of photoresist 5 (FIG. 4) in which for exposition and development are subsequently made windows 6 at the zones designed to receive the conductors (FIG. 5).

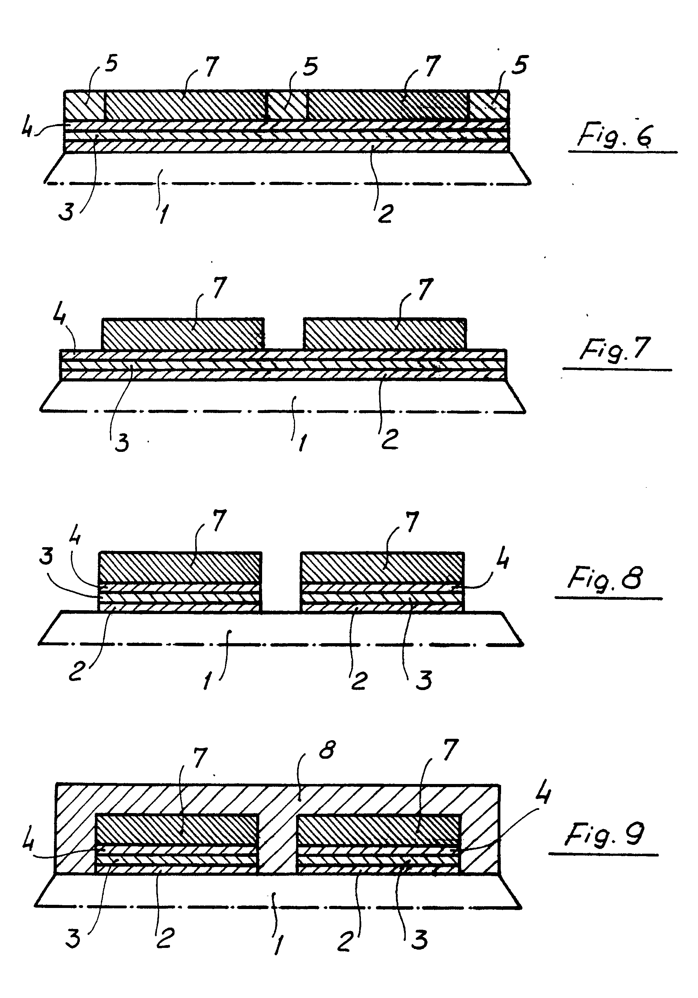

After washing of the areas of the windows 6 and drying of the photoresist 5 in an oven in the abovespecified areas gold is electrodeposited so as to form conducting lines 7 (FIG. 6).

The layer of photoresist 5 is then removed (FIG. 7) to allow subsequent removal by chemical etching of the palladium 4, titanium nitride 3 and tantalium oxynitride 2 from the areas which are not protected by the conducting lines 7 (FIG. 8).

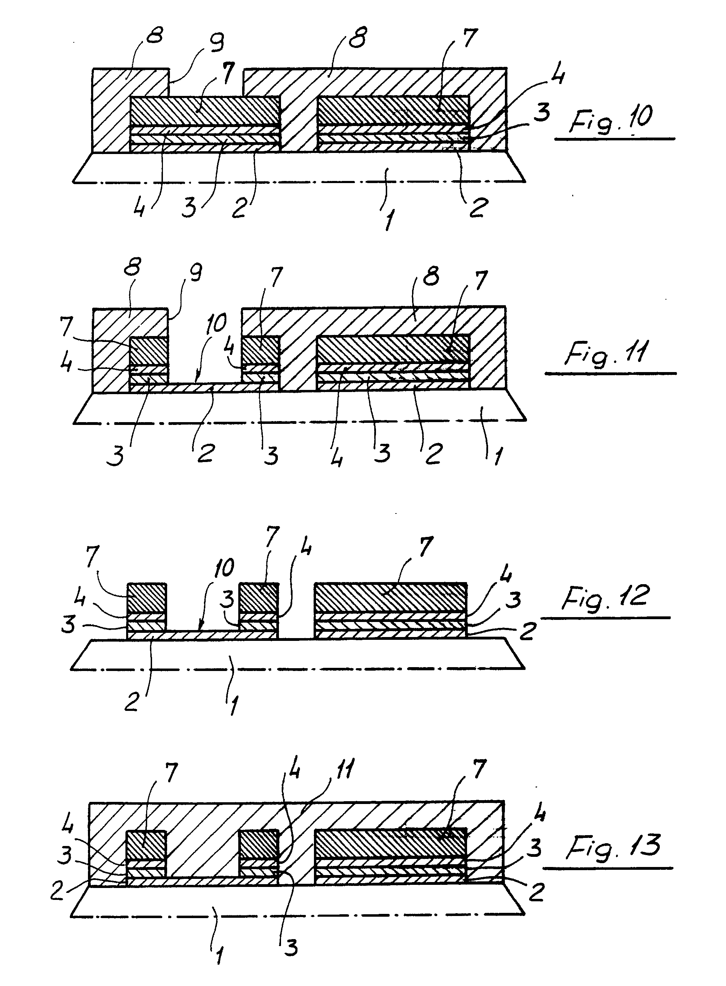

The structure thus obtained is completely covered with a thick layer of photoresist 8 (FIG. 9) in which by exposition and development are then created windows 9 (FIG. 10) to uncover the zones of the conductors 7 which are to be etched chemically to obtain the resistive lines having greater resistivity.

This operation is subsequently performed by selective chemical etching of the layers of gold 7, palladium 4 and titanium 3 in the uncovered areas while the underlying layer of tantalium 2 being doped differently resists the etching and thus forms resistive lines 10 with resistivity of between 350 and 450 μohm.cm and thickness of approximately 30nm (300Å) (FIG. 11).

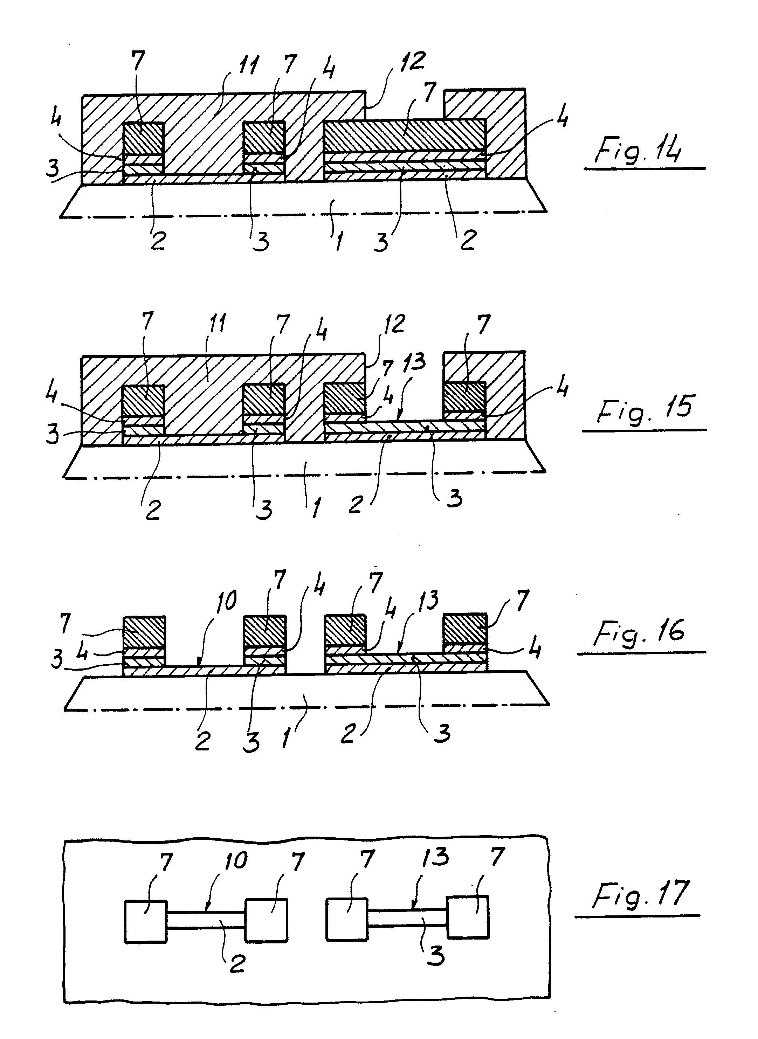

The residual layer of photoresist 8 is removed (FIG. 12) and replaced with a new thick layer of photoresist 11 (FIG. 13) in which are created by exposition and development windows 12 (FIG. 14) coinciding with the areas intended for formation of the resistive lines of less resistivity.

In said areas is performed by selective chemical etching removal of the layers of gold 7 and palladium 4 leaving unchanged the superimposed layers of titanium 3 and tantalium 2 which form resistive lines 13 having resistivity between 200 and 250 μohm.cm and thickness of approximately 100nm (1000Å) (FIG. 15).

The photoresist 11 is subsequently removed so as to uncover the final structure shown in FIGS. 16 and 17, i.e. a passive circuit consisting of an insulating substrate 1, a conducting line 7 and resistive lines 10 and 13 which have greater and lesser resistances respectively.

The circuit is finally subjected to cleaning and stabilization of the resistors 10 and 13 by oxidation of the layers at 300-340°C in a circulating air oven.

The principal benefits of the process in accordance with the invention and of the circuit produced thereby can be summarized as follows: (1) the titanium and the tantalium are compatible materials which can remain in contact and being doped differently are also selective in relation to chemical etching so as to allow removal when and where desired of only the titanium for formation of the resistive lines having greater resistance, (2) the titanium acts as an adhesive layer between the two resistive layers and the superimposed conductive layer and at the same time the palladium acts as a barrier to prevent spreading of the titanium into the gold of the conductors, (3) the various resistive layers are deposited by cathodic pulverization in a single vacuum cycle and the speed of the basic metallization is therefore very high, and (4) the process is generally very simple and rapid and in particular the two resistive layers are obtained by the addition of a single photoengraving step to the standard cycle used for obtaining passive thin-layer circuits by nitride and tantalium technology. This means the materials and equipment already available can be used with obvious savings.

## Claims

1. Process for obtaining passive thin-layer circuits with resistive lines having different layer resistances formed by superimposition of an upper layer (3) having less resistivity and a lower layer (2) having greater resistivity characterized in that tantalium treated with a first dopant consisting of nitrogen and oxygen is used for the lower layer (2) and titanium treated with a second dopant consisting of nitrogen is used for the upper layer (3).

2. Process in accordance with claim 1 characterized in that said lower layer (2) is thinner than said upper layer (3).

3. Process in accordance with claim 1 characterized in that a thick layer (7) of electrically conductive material is superimposed on part of said resistive layers (2, 3) for formation of the conducting lines.

4. Process in accordance with claim 1 characterized in that said conducting material is gold.

5. Process in accordance with claim 5 characterized in that a layer of palladium (4) is interposed between said resistive layers (2, 3) and said conducting layer (7) with the function of a barrier against spreading of the titanium into the conducting material.

6. Process in accordance with claim 1 characterized in that said layers of tantalium and titanium (2, 3) are deposited in a single vacuum cycle.

7. Process in accordance with claim 5 characterized in that said layers of tantalium, titanium and palladium (2, 3, 4) are deposited in a single vacuum cycle.

8. Process in accordance with claim 1 characterized in that it includes the following sequential steps:

A) cathodic pulverization in a vacuum of a lower layer (2) of tantalium doped with nitrogen and oxygen with high resistivity and limited thickness on an insulating substrate (1),

B) cathodic pulverization in a vacuum in the same vacuum cycle of an upper layer (3) of titanium doped with nitrogen with low resistivity and greater thickness,

C) cathodic pulverization in a vacuum in the same vacuum cycle of a layer of palladium (4),

D) deposit of a thick layer of photoresist (5) and opening of windows (6) in said photoresist (5),

E) deposit of conducting material (7) in the areas described by said windows (6),

F) removal of the photoresist (5),

G) removal of the palladium (4), titanium (3) and tantalium (2) at the sides of the area covered with conductive material (7),

H) deposit of a thick layer of photoresist (8) and opening of windows (9) in said photoresist (8),

I) removal by selective chemical etching of conducting material (7), palladium (4) and titanium (3) in the areas described by said windows (9),

L) removal of the photoresist (8) and deposition of another thick layer of photoresist (11) with opening of windows (12),

M) removal by selective chemical etching of conducting material (7) and palladium (4) in the areas described by said windows (12), and

N) removal of the photoresist (11).

9. Passive thin-layer circuit with resistive lines of different layer resistances, the resistive lines with greater resistance (10) being formed of individual layers of a first material with greater resistivity (2) and the resistive lines with less resistance (13) being formed of multiple layers obtained by superimposition of a second material with less resistivity (3) to said first material with greater resistivity (2) characterized in that said first material (2) consists of tantalium treated with a first dopant consisting of nitrogen and oxygen and said second material (3) consists of titanium treated with a second dopant consisting of nitrogen.

10. Passive circuit in accordance with claim 9 characterized in that it includes a layer of palladium (4) superimposed on a part of said resistive layers (2, 3) and a layer of conducting material (7) superimposed on said layer of palladium (4).

**Revendications**

1. Procédé de réalisation de circuits passifs à couches minces avec des conduites résistives ayant différentes résistances de couche formées par superposition d'une couche supérieure (3) ayant une plus faible résistivité et d'une couche inférieure (2) ayant une plus grande résistivité, caractérisé en ce que l'on utilise pour la couche inférieure (2) du tantale traité par un premier dopant consistant en azote et en oxygène et pour la couche supérieure (3) du titane traité par un second dopant consistant en azote.

2. Procédé selon la revendication 1, caractérisé en ce que ladite couche inférieure (2) est plus mince que ladite couche supérieure (3).

3. Procédé selon la revendication 1, caractérisé en ce qu'une couche épaisse (7) en matériau électriquement conducteur est disposée sur une partie desdites couches résistives (2, 3) pour la formation des conduites conductrices.

4. Procédé selon la revendication 1, caractérisé en ce que ledit matériau conducteur est l'or.

5. Procédé selon la revendication 5, caractérisé en ce qu'une couche de palladium (4), qui joue le rôle de barrière contre la propagation du titane dans le matériau conducteur, est disposée entre lesdites couches résistives (2, 3) et ladite couche conductrice (7).

6. Procédé selon la revendication 1, caractérisé en ce que lesdites couches de tantale et de titane (2, 3) sont déposées en un seul cycle de vide.

7. Procédé selon la revendication 5, caractérisé en ce que lesdites couches de tantale, de titane et de palladium (2, 3, 4) sont déposées en un seul cycle de vide.

8. Procédé selon la revendication 1, caractérisé en ce qu'il comprend les étapes successives suivantes :

A) pulvérisation cathodique sous vide sur un substrat isolant (1) d'une couche inférieure (2) de tantale dopé par de l'azote et de l'oxygène, à haute résistivité et épaisseur limitée,

B) pulvérisation cathodique sous vide dans le même cycle de vide d'une couche supérieure (3) de titane dopé par de l'azote, à faible résistivité et épaisseur plus importante,

C) pulvérisation cathodique sous vide dans le même cycle de vide d'une couche de palladium (4),

D) dépôt d'une couche épaisse de résine photosensible (5) et ouverture de fenêtres (6) dans ladite résine photosensible (5),

E) dépôt d'un métal conducteur (7) dans les zones définies par lesdites fenêtres (6),

F) élimination de la résine photosensible (5),

G) élimination du palladium (4), du titane (3) et du tantale (2) au niveau des côtés de la zone recouverte par le matériau conducteur (7),

H) dépôt d'une couche épaisse de résine photosensible (8) et ouverture de fenêtres (9) dans ladite résine photosensible (8),

I) élimination par attaque chimique sélective du matériau conducteur (7), du palladium (4) et du titane (3) dans les zones définies par lesdites fenêtres (9),

L) élimination de la résine photosensible (8) et dépôt d'une autre couche épaisse de résine photosensible (11) avec ouverture de fenêtres (12),

M) élimination par attaque chimique sélective du matériau conducteur (7) et du palladium (4) dans les zones définies par lesdites fenêtres (12), et

N) élimination de la résine photosensible (11).

9. Circuit passif à couches minces avec des conduites résistives présentant différentes résistances de couche, les conduites résistives de plus grande résistance (10) étant formées de couches individuelles d'un premier matériau de plus grande résistivité (2) et les conduites résistives de moindre résistance (13) étant formées de couches multiples obtenues par disposition d'un second matériau de moindre résistivité sur ledit premier matériau de plus grande résistivité (2), caractérisé en ce que ledit premier matériau (2) consiste en tantale traité par un premier dopant consistant en azote et en oxygène et ledit second matériau (3) consiste en titane traité par un second dopant consistant en azote.

10. Circuit passif selon la revendication 9, caractérisé en ce qu'il comprend une couche de palladium (4) disposée sur une partie desdites couches résistives (2, 3) et une couche de matériau conducteur (7) disposée sur ladite couche de palladium (4).

**Patentansprüche**

1. Verfahren zum Herstellen von passiven Dünnschicht-Schaltungen mit Widerstandsleitungen mit verschiedenen Schichtwiderständen, die durch Überlagerung einer oberen Schicht (3) mit geringerem Widerstand und einer unteren Schicht (2) mit größerem Widerstand gebildet werden, dadurch gekennzeichnet, daß mit einem aus Stickstoff und Sauerstoff bestehenden ersten Dotiermittel behandeltes Tantal für die untere Schicht (2) benutzt wird und mit einem aus Stickstoff bestehenden zweiten Dotiermittel behandeltes Titan für die obere Schicht (3) benutzt wird.

2. Verfahren nach Anspruch 1, dadurch gekennzeichnet, daß die untere Schicht (2) dünner als die obere Schicht (3) ist.

3. Verfahren nach Anspruch 1, dadurch gekennzeichnet, daß eine dicke Schicht (7) aus einem elektrisch leitenden Material auf einem Teil der Widerstandsschichten (2, 3) zum Bilden der leitenden Leitungen aufgebracht ist.

4. Verfahren nach Anspruch 1, dadurch gekennzeichnet, daß das leitende Material Gold ist.

5. Verfahren nach Anspruch 5, dadurch gekennzeichnet, daß eine Schicht aus Palladium (4) zwischen den Widerstandsschichten (2, 3) und der leitenden Schicht (7) mit der Funktion als Barriere gegen das Ausbreiten des Titans in das leitende Material vorgesehen ist.

6. Verfahren nach Anspruch 1, dadurch gekennzeichnet, daß die Schichten aus Tantal und Titan (2, 3) in einem einzigen Vakuumzyklus abgeschieden werden.

7. Verfahren nach Anspruch 5, dadurch gekennzeichnet, daß die Schichten aus Tantal, Titan und Palladium (2, 3, 4) in einem einzigen Vakuumzyklus abgeschieden werden.

8. Verfahren nach Anspruch 1, dadurch gekennzeichnet, daß die folgenden aufeinanderfolgenden Schritte vorgesehen sind:

A) Kathodenzerstäuben in einem Vakuum einer mit Stickstoff und Sauerstoff dotierten unteren Schicht (2) auf Tantal mit hohem Widerstand und begrenzter Dicke auf ein isolierendes Substrat (1),

B) Kathodenzerstäuben im Vakuum während des gleichen Vakuumzyklus einer mit Stickstoff dotierten oberen Schicht (3) aus Tantal mit niedrigem Widerstand und größerer Dicke,

C) Kathodenzerstäuben im Vakuum in dem gleichen Vakuumzyklus einer Schicht aus Palladium (4),

D) Abscheiden einer dicken Schicht eines Fotolackes (5) und Öffnen von Fenstern (6) in dem Fotolack (5),

E) Abscheiden eines leitenden Materiales (7) in den durch die Fenster (6) beschriebenen Flächen,

F) Entfernen des Fotolackes (5),

G) Entfernen des Palladiums (4), des Titans (3) und des Tantals (2) an den Seiten der mit dem leitenden Material (7) bedeckten Fläche,

H) Abscheiden einer dicken Schicht eines Fotolackes (8) und Öffnen von Fenstern (9) in dem Fotolack (8),

I) Entfernen durch selektives chemisches Ätzen von leitendem Material (7), Palladium (4) und Titan (3) in den durch die Fenster (9) beschriebenen Flächen,

L) Entfernen des Fotolackes (8) und Abscheiden einer anderen dicken Schicht von Fotolack (11) mit Öffnen von Fenstern (12),

M) Entfernen durch selektives chemisches Ätzen von leitendem Material (7) und Palladium (4) in den durch die Fenster (12) beschriebenen Flächen, und

N) Entfernen des Fotolackes (11).

9. Passive Dünnschicht-Schaltung mit Widerstandsleitungen mit verschiedenen Schichtwiderständen, wobei Widerstandsleitungen mit größerem Widerstand (10) aus individuellen Schichten eines ersten Materiales mit größerem Widerstand (2) gebildet sind und die Widerstandsleitungen mit geringerem Widerstand (13) aus verschiedenen, durch Überlagerung eines zweiten Materiales mit geringerem Widerstand (3) auf dem ersten Material mit größerem Widerstand (2) erhaltenen Schichten gebildet sind, dadurch gekennzeichnet, daß das erste Material (2) aus mit einem ersten Dotiermittel, das aus Stickstoff und Sauerstoff besteht, behandeltem Tantal besteht Und das zweite Material (3) aus mit einem zweiten Dotiermittel, das aus Stickstoff besteht, behandeltem Titan besteht.

10. Passive Schaltung nach Anspruch 9, dadurch gekennzeichnet, daß sie eine Schicht aus Palladium (4), die einem Teil der Widerstandsschichten (2, 3) überlagert ist, und eine Schicht aus leitendem Material, die der Schicht aus Palladium (4) überlagert ist, enthält.

Fig. 1

Fig. 2

Fig. 3

Fig. 4

Fig. 5

Fig. 6

Fig. 7

Fig. 8

Fig. 9

_Fig. 10_

_Fig. 11_

_Fig. 12_

_Fig. 13_

*Fig. 14*

*Fig. 15*

*Fig. 16*

*Fig. 17*